# EUROPEAN PATENT APPLICATION

(11) **EP 4 329 449 A1**
(43) Date of publication of application: **28.02.2024**
(21) Application number: 22862692.5
(22) Date of filing: 07.05.2022
(51) Int. Cl.: H05K 7/20, F24F 11/00

(54) **HEATING CONTROL METHOD AND APPARATUS OF ELECTRIC CONTROL BOX, AND AIR CONDITIONER**

(30) Priority: 31.08.2021 CN 202111017019
(71) Applicant: HEFEI MIDEA HEATING & VENTILATING EQUIPMENT CO., LTD., Boyan Science Park, High-Tech Zone, Hefei Anhui 230088 (CN); GD Midea Heating & Ventilating Equipment Co., Ltd., Foshan, Guangdong 528311 (CN)
(72) Inventor: LIU, Guofeng, Foshan, Guangdong 528311 (CN); WU, Tian, Foshan, Guangdong 528311 (CN); CHEN, Tingbo, Foshan, Guangdong 528311 (CN); QIAN, Xiong, Foshan, Guangdong 528311 (CN); WEN, Yonghe, Foshan, Guangdong 528311 (CN)
(74) Representative: Whitlock, Holly Elizabeth Ann
(86) International application number: PCT/CN2022/091549
(87) International publication number: WO 2023/029549

(57) **Abstract**

The present application relates to the technical field of air conditioning devices, and discloses a heating control method and apparatus of an electric control box, and an air conditioner, used for solving the technical problem that components inside the electric control box are prone to damage during heating of a heating assembly. A heat dissipation method of the electric control box comprises: obtaining a measured temperature from a temperature sensor in the electric control box; controlling the heating assembly in the electric control box according to the measured temperature to heat the electric control box; according to the heating time of the heating assembly, sequentially driving circulation fans in the electric control box to perform internal circulation heating on the electric control box. According to the heat dissipation control method and apparatus of the electric control box and the air conditioner disclosed in the present application, the heating assembly is controlled to heat the electric control box according to the measured temperature, and the circulation fans are controlled to perform internal circulation heating, thereby lowering the probability of damage to the components inside the electric control box caused by excessively high temperature of an accessory area of the heating assembly.

## Description

This application claims priority to Chinese Patent Application No. 202111017019.3, filed on August 31, 2021 and entitled "HEATING CONTROL METHOD AND APPARATUS FOR ELECTRIC CONTROL BOX, AND AIR CONDITIONER". The content of the above application is hereby incorporated by reference in its entirety.

### TECHNICAL FIELD

The present application relates to the technical field of air conditioning devices and, in particular, to a heating control method and apparatus for an electric control box, and an air conditioner.

### BACKGROUND

When an air conditioning device operates in a low temperature environment, the performance of its components may be degraded, especially the electrolytic capacitor capacity of the main circuit will be attenuated, resulting in low reliability of the air conditioning device. In order to avoid the influence of low ambient temperature, the existing air conditioning device usually has a heating component provided inside, so that the heating component is used to heat the electric control box in the air conditioning device when the ambient temperature is low. However, there may be hidden dangers such as high dry burning temperature when heating with the heating component, which will cause a greater probability of damage to the components inside the electric control box.

### SUMMARY

The main purpose of the present application is to provide a heating control method and apparatus for an electric control box and an air conditioner, aiming at solving the technical problem that components inside the electric control box are more likely to be damaged when a heating component is heated.

In order to achieve the above purpose, a heating control method for an electric control box provided by the present application includes:
a controller of an air conditioner firstly acquires a detected temperature of a temperature sensor in the electric control box. Subsequently, the controller of the air conditioner controls a heating component in the electric control box to heat the electric control box according to the detected temperature. Finally, the controller of the air conditioner sequentially drives circulating fans in the electric control box to conduct internal circulation heating of the electric control box according to a heating time of the heating component.

According to the embodiments of the present application, the heating component is controlled to heat the electric control box according to the detected temperature, and the circulating fans are controlled to conduct internal circulation heating, so that the probability that the components inside the electric control box are damaged due to over-high temperature in an accessory area of the heating component is reduced.

On the basis of the above technical scheme, the following improvements can also be achieved in the present application.

Optionally, the circulating fan includes a first circulating fan and a second circulating fan, where the first circulating fan is configured to blow the air in the electric control box in a first direction of the first circulating fan, and the second circulating fan is configured to blow the air in the electric control box in a second direction of the second circulating fan, the first circulating fan is adjacent to the heating component, the second circulating fan is disposed in the first direction of the first circulating fan, and the first circulating fan is disposed in the second direction of the second circulating fan. In this way, the first circulating fan and the second circulating fan can form air circulation during operation, so as to realize circulating heat dissipation inside the electric control box.

Optionally, the sequentially driving the circulating fans in the electric control box to conduct the internal circulation heating of the electric control box according to the heating time of the heating component includes: driving the first circulating fan to operate in response to the heating time of the heating component exceeds a first time threshold.

Optionally, the sequentially driving the circulating fans in the electric control box to conduct the internal circulation heating of the electric control box according to the heating time of the heating component further includes: driving the second circulating fan to operate in response to an operating time of the first circulating fan exceeds a second time threshold.

Optionally, after the sequentially driving the circulating fans in the electric control box to conduct the internal circulation heating of the electric control box according to the heating time of the heating component, the method further includes: starting a main power loop in the electric control box in response to the operating time of the first circulating fan exceeding a third time threshold.

Optionally, the controller of the air conditioner may control the heating component in the electric control box to heat the electric control box in accordance with a determination that the detected temperature of the temperature sensor is less than a first temperature threshold. In this way, the electric control box can be heated only when the temperature of the temperature sensor is less than the setting first temperature threshold, thus reducing the power consumption and realizing the effect of automatically heating the electric control box based on the environment.

Optionally, the controller of the air conditioner starts a main power loop in the electric control box in accordance with a determination that the detected temperature of the temperature sensor is greater than or equal to a first temperature threshold.

Optionally, after the starting the main power loop in the electric control box, the method further includes: controlling a working state of the heating component according to a temperature interval where the detected temperature is disposed.

Optionally, the controlling the working state of the heating component according to the temperature interval where the detected temperature is disposed includes: in response to the detected temperature is disposed in a first temperature interval, controlling the heating component to be in an on state; in response to the detected temperature is disposed in a second temperature interval, controlling the state of the heating component to be unchanged; and in response to the detected temperature is disposed in a third temperature interval, controlling the heating component to be in an off state.

Among them, the first temperature interval is an interval less than a first temperature threshold, the second temperature interval is an interval greater than or equal to the first temperature threshold and less than a second temperature threshold, the third temperature interval is an interval greater than or equal to the second temperature threshold, where the first temperature interval is less than the second temperature threshold.

Optionally, the temperature sensor is configured to detect a cavity temperature of the electric control box.

Optionally, the heating component includes a positive temperature coefficient thermistor.

The present application also provides a heating control apparatus for an electric control box, including:
an acquiring module, configured to acquire a detected temperature of a temperature sensor in the electric control box;
a controlling module, configured to control a heating component in the electric control box to heat the electric control box according to the detected temperature; and
a driving module, configured to sequentially drive circulating fans in the electric control box to conduct internal circulation heating of the electric control box according to a heating time of the heating component.

Optionally, the circulating fans include a first circulating fan and a second circulating fan, where the first circulating fan is configured to blow the air in the electric control box in a first direction of the first circulating fan, and the second circulating fan is configured to blow the air in the electric control box in a second direction of the second circulating fan, the first circulating fan is adjacent to the heating component, the second circulating fan is disposed in the first direction of the first circulating fan, and the first circulating fan is disposed in the second direction of the second circulating fan.

Optionally, the driving module is specifically configured to drive the first circulating fan to operate in response to the heating time of the heating component exceeds a first time threshold.

Optionally, the driving module is specifically configured to drive the second circulating fan to operate in response to an operating time of the first circulating fan exceeds a second time threshold.

Optionally, the controlling module is further configured to start a main power loop in the electric control box in response to the operating time of the first circulating fan exceeds a third time threshold.

Optionally, the controlling module is specifically configured to control the heating component in the electric control box to heat the electric control box in accordance with a determination that the detected temperature of the temperature sensor is less than a first temperature threshold.

Optionally, the controlling module is further configured to start a main power loop in the electric control box in accordance with a determination that the detected temperature of the temperature sensor is greater than or equal to a first temperature threshold.

Optionally, the controlling module is further configured to control a working state of the heating component according to a temperature interval where the detected temperature is disposed.

Optionally, the controlling module is specifically configured to, in response to the detected temperature is disposed in a first temperature interval, control the heating component to be in an on state; in response to the detected temperature is disposed in a second temperature interval, control the state of the heating component to be unchanged; and in response to the detected temperature is disposed in a third temperature interval, control the heating component to be in an off state.

Among them, the first temperature interval is an interval less than a first temperature threshold, the second temperature interval is an interval greater than or equal to the first temperature threshold and less than a second temperature threshold, the third temperature interval is an interval greater than or equal to the second temperature threshold, where the first temperature interval is less than the second temperature threshold.

Optionally, the temperature sensor is configured to detect a cavity temperature of the electric control box.

Optionally, the heating component includes a positive temperature coefficient thermistor.

The present application also provides an air conditioner, including an electric control box, a compressor and a controller; where
the electric control box is configured to control refrigeration of the compressor, and the electric control box is provided with a heating component, a temperature sensor and circulating fans; the controller is configured to:
acquire a detected temperature of the temperature sensor in the electric control box;
control the heating component in the electric control box to heat the electric control box according to the detected temperature; and
sequentially drive the circulating fans in the electric control box to conduct internal circulation heating of the electric control box according to a heating time of the heating component.

The present application also provides a computer program product, including a computer program, when the computer program is executed by a processor, the heating control method for an electric control box described in any one of the above technical schemes is realized.

The present application also provides a computer storage medium, where the computer storage medium stores a plurality of instructions, and the instructions are suitable for being loaded by a processor and executing the steps of the heating control method for an electric control box according to any one of the above technical schemes.

According to the heating control method and apparatus for an electric control box and the air conditioner provided by the embodiments of the present application, the heating component is controlled to heat the electric control box according to the detected temperature, and the circulating fans are controlled to conduct internal circulation heating, so that the probability of the components inside the electric control box are damaged due to over-high temperature in an accessory area of the heating component is reduced.

### BRIEF DESCRIPTION OF DRAWINGS

In order to explain the embodiments of the present application or the technical scheme in the prior art more clearly, the drawings needed to be used in the description of the embodiments or the prior art will be briefly introduced below. Apparently, the described drawings below are merely some rather than all of the embodiments of the present application. Other drawings can be acquired by a person of ordinary skill in the art based on the structures shown in these drawings without paying creative efforts.
FIG. 1 is a schematic diagram of an existing air conditioning device provided by an embodiment of the present application.
FIG. 2 is a schematic flowchart of a heating control method for an electric control box provided by an embodiment of the present application.
FIG. 3 is a schematic diagram of an electric control box provided by an embodiment of the present application.
FIG. 4 is a schematic flowchart of another heating control method for an electric control box provided by an embodiment of the present application.
FIG. 5 is a schematic flowchart of yet another heating control method for an electric control box provided by an embodiment of the present application.
FIG. 6 is a schematic diagram of a heating control apparatus for an electric control box provided by an embodiment of the present application.
FIG. 7 is a schematic diagram of an air conditioner provided by an embodiment of the present application.
FIG. 8 is a schematic diagram of an electronic device provided by an embodiment of the present application.

### Reference numerals

| Numeral | Name | Numeral | Name |
|---|---|---|---|
| 001 | Electric control box | 002 | Electric heating component |
| 003 | External fan | 110 | First circulating fan |
| 120 | Second circulating fan | 130 | PTC thermistor |
| 140 | Temperature sensor | | |

### DESCRIPTION OF EMBODIMENTS

For the existing air conditioning device, an internal temperature of an electric control box is usually the same as the surrounding because the electric control box uses convection of external air to dissipate heat. When the air conditioning device operates in a low temperature environment, performance of its components may be degraded, especially an electrolytic capacitor capacity of a main circuit will be attenuated, resulting in low reliability of the air conditioning device.

There are usually two ways to solve the reliability problem of air conditioning device operating in low temperature environment in related art.

In a first way, low temperature components can be used in the electric control box, thus avoiding an influence of low temperature environment on the air conditioning device. However, the use of low temperature components will increase the cost of the air conditioning device, and the air conditioning device needs to be customized according to the environment, which is not advantageous for generalization.

In a second way, a heating component can be set inside the air conditioning device, so that the heating component can be used to heat the electric control box in the air conditioning device when the ambient temperature is low.

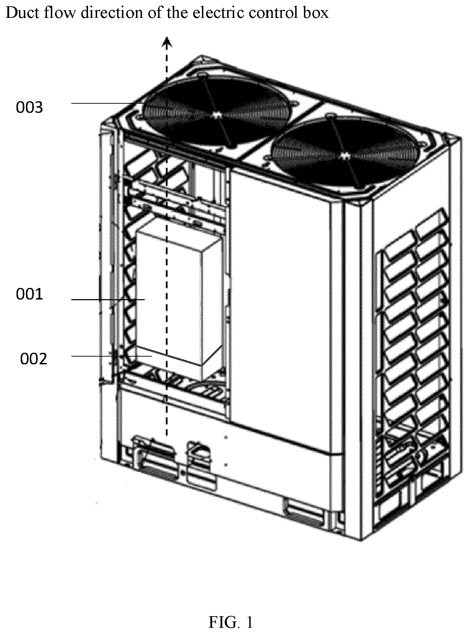

FIG. 1 is a schematic diagram of an existing air conditioning device provided by an embodiment of the present application. As shown in FIG. 1, the air conditioning device includes an electric control box 001, an electric heating component 002 and external fans 003. The structure of the air conditioning device shows the heating and heat dissipating modes of the electric control box in the air conditioning device.

For the heat dissipating mode of the electric control box in the air conditioning device, the outdoor air of the electric control box 001 and the indoor air of the electric control box 001 can be circulated by the external fans 003, so as to realize an internal convection heat dissipation of the electric control box 001. Because the internal circulating air of the electric control box 001 is outdoor air, the inlet air temperature of the electric control box 001 is the same as the outdoor ambient air temperature.

For the heating mode of the electric control box in the air conditioning device, the electric heating component 002 can be set at the bottom of the electric control box 001. When the electric control box 001 needs to be heated, the electric heating component 002 can be turned on, then the outdoor air of the electric control box 001 and the indoor air of the electric control box 001 can be circulated through the external fans 003. The indoor air heated by the electric heating module 002 can heat the components inside the electric control box 001.

However, because the heating component of the existing air conditioning devices are set outside the electric control box, and the electric control box is heated by heating the outside air, the power of the heating component is high, which not only consumes electricity, but also has hidden dangers such as high dry burning temperature, which will cause a greater probability of damage to the components inside the electric control box. Moreover, in response to the air convection in the electric control box is to be generated, the external fans need to be turned on, and low temperature characteristics of a fan control device also require special treatment.

In order to solve the above problems, the present application provides a heating control method and apparatus for an electric control box and an air conditioner. In the embodiments of the present application, in the process of heating the electric control box, according to a heating time of the heating component, circulating fans in the electric control box is driven to conduct internal circulation heating of the electric control box, so that the temperature inside the electric control box is avoided to be balanced, and the probability that the components inside the electric control box are damaged due to over-high temperature in an accessory area of the heating component is avoided.

The following clearly and comprehensively describes technical solutions in the embodiments of the present application with reference to the accompanying drawings in the embodiments of the present application. Apparently, the described embodiments are merely some rather than all of the embodiments of the present application. Other embodiments acquired by a person of ordinary skill in the art based on the embodiments of the present application without paying creative efforts shall fall within the scope of protection of the present application.

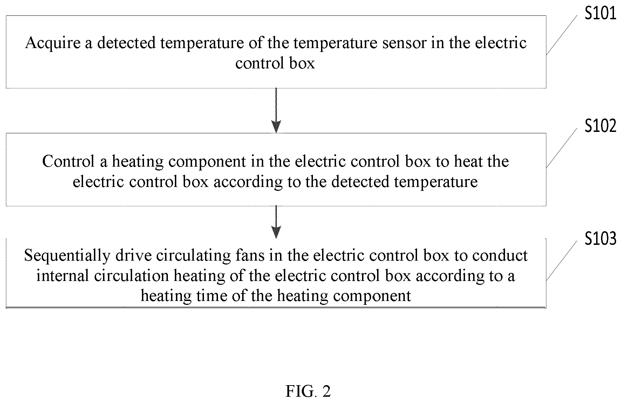

FIG. 2 is a schematic flowchart of a heating control method for an electric control box provided by an embodiment of the present application. As shown in FIG. 2, it provides a specific method of heating an electric control box in the embodiments of the present application. The executive subject of this embodiment is a controller. As shown in FIG. 2, the heating control method for the electric control box includes the following steps.

S 101: acquire a detected temperature of a temperature sensor in the electric control box.

In the present application, in response to the controller detects that a compressor in the air conditioner starts to operate, the electric control box in the air conditioner will start to work accordingly. At this time, it is necessary to acquire the detected temperature of the temperature sensor in the electric control box, so as to determine whether the temperature of the electric control box can meet a reliability condition during operation based on the detected temperature of the temperature sensor.

In some embodiments, the temperature sensor provided in the electric control box can be configured to detect a cavity temperature of the electric control box, so as to monitor an operating environment of the components in the electric control box in real time.

It should be noted that an installation position of the temperature sensor in the electric control box is not limited in the embodiments of the present application. In some embodiments, the temperature sensor can be installed in any area inside the electric control box, but it needs to be avoided to be installed near the heating component, so as to avoid the influence of the heat generated by the heating component on the detected temperature, which results in the detected temperature collected being higher than the actual cavity temperature.

In some other embodiments, a plurality of temperature sensors can be provided in the electric control box, and the cavity temperature of the electric control box can be collected at the same time. Subsequently, after acquiring the detected temperatures of the plurality of temperature sensors, the controller can control operation of the heating component according to an average value of the detected temperatures of the plurality of temperature sensors. Optionally, the controller can control the operation of the heating component according to the highest value of the detected temperatures of the plurality of temperature sensors after acquiring the detected temperatures of the plurality of temperature sensors.

It should be understood that the embodiments of the present application also do not limit when the detected temperature of the temperature sensor is acquired. In some embodiments, when the electric control box is powered on, the detected temperature of the temperature sensor in the electric control box can be acquired. In some embodiments, the detected temperature of the temperature sensor in the electric control box can be acquired immediately when the compressor of the air conditioner starts working. In some other embodiments, in response to the electric control box is powered on, the detected temperature of the temperature sensor in the electric control box can be acquired at a first time point before the compressor is turned on.

The first time point can be specifically set based on the actual situation, for example, 5 seconds, 7 seconds, 10 seconds, etc.

S102: control a heating component in the electric control box to heat the electric control box according to the detected temperature.

In the present application, after the controller acquires the detected temperature of the temperature sensor, it can determine whether to turn on the heating component according to the detected temperature.

It should be understood that the embodiments of the present application do not limit the type of the heating component, and an appropriate heating component type can be selected according to the actual situation. In some embodiments, the heating component may include a positive temperature coefficient (Positive Temperature Coefficient, PTC) thermistor. When electric heating is dry-fired, due to the characteristics of the PTC thermistor, the resistance of the PTC thermistor increases, the power decreases, and a surface temperature reaches a certain value, but this maximum temperature will not damage the components around the PTC thermistor, thus playing a certain role in protecting the components in the electric control box. Moreover, due to the internal circulation of air in the electric control box, it can keep warm to a certain extent, thus making the power of the PTC thermistor smaller.

It should be understood that the embodiments of the present application do not limit how to control the heating component in the electric control box according to the detected temperature. In some embodiments, the first temperature threshold can be set in advance. After the controller acquires the detected temperature, it can compare the detected temperature with the first temperature threshold to determine whether the detected temperature of the temperature sensor is less than the first temperature threshold. In response to the detected temperature is less than the first temperature threshold, it is determined that the temperature in the electric control box is too low to meet the reliability requirements for direct operation. At this time, the heating component in the electric control box can be controlled to heat the electric control box, and at the same time, the circulating fans and the main circuit are temporarily out of operation. In response to the detected temperature is greater than or equal to the first temperature threshold, the controller determines that the temperature in the electric control box is not too high and can meet the reliability requirements. At this time, the main circuit can be started to operate directly without starting the heating component.

It should be noted that the first temperature threshold is not limited in the embodiments of the present application, and it can be specifically set according to the actual situation, for example, it can be 0 degrees Celsius, 5 degrees Celsius, -10 degrees Celsius, etc.

Illustratively, the first temperature threshold can be set to a. When the air conditioning device receives a power-on instruction, it can acquire the detected temperature T of the temperature sensor in the cavity of the electric control box. In response to the detected temperature T of the temperature sensor is greater than the first temperature threshold value a, the heating component is not started, and the main power loop is started to operate. In response to the sensor temperature T is less than the preset value a, the heating component is turned on for preheating, and the fan does not operate temporarily.

S 103: sequentially drive circulating fans in the electric control box to conduct internal circulation heating of the electric control box according to a heating time of the heating component.

In the embodiment of the present application, the heating component can be preheated after being started, so that the temperature of the heating component can be raised to a preset temperature; after the temperature of the heating component is raised to the preset temperature, the circulating fans in the electric control box can be sequentially driven to conduct the internal circulation heating of the electric control box, so that the cavity temperature of the electric control box can be raised.

It should be understood that in the embodiment of the present application, whether the preheating of the heating component is completed can be determined by the heating time of the heating component. For example, a preheating time of the heating component can be set to X seconds, and when the heating time of the heating component exceeds X seconds, it can be determined that the heating component has finished preheating, and at this time, the circulating fans can be started to heat the electric control box to conduct the internal circulation heating.

It should be understood that the embodiments of the present application do not limit the number of circulating fans. In some embodiments, the number of circulating fans can be two, and in some other embodiments, the number of circulating fans can be three or even more.

Illustratively, the circulating fan may include a first circulating fan and a second circulating fan. The first circulating fan is configured to blow the air in the electric control box to a first direction of the first circulating fan, and the second circulating fan is configured to blow the air in the electric control box to a second direction of the second circulating fan.

It should be understood that the embodiments of the present application do not restrict the installation position of the circulating fans. For example, the first circulating fan may be adjacent to the heating component, the second circulating fan may be disposed in the first direction of the first circulating fan, and the first circulating fan may be disposed in the second direction of the second circulating fan.

Among them, the first direction of the first circulating fan and the second direction of the second circulating fan can be opposite directions, so that the first circulating fan blows the air to the second circulating fan, and the second circulating fan blows the air to the first circulating fan, thereby forming air circulation and realizing the internal circulation heating of the electric control box.

It should be understood that the embodiments of the present application do not limit when the circulating fan is started. In some embodiments, in response to the heating time of the heating component exceeds a first time threshold, the first circulating fan is driven to operate. In response to an operating time of the first circulating fan exceeds a second time threshold, the second circulating fan is driven to operate.

In some embodiments, in response to the operating time of the first circulating fan exceeds a third time threshold, a main power loop in the electric control box is started.

Illustratively, when the heating time T of the heating component reaches the first time threshold of X seconds, a bearing grease of the first circulating fan is electrically heated to a target temperature by thermal radiation, and then the first circulating fan is driven to start to operate. When the operating time of the first circulating fan reaches the second time threshold of Y seconds, the first circulating fan transfers the heat of electric heating to the second circulating fan, the bearing grease of the first circulating fan is heated to the target temperature, and then the second circulating fan is driven to start to operate. When a starting time of the first circulating fan reaches Z seconds, the heat of electric heating has been uniformly transferred to the electric control box by the two circulating fans, and at this time, the main power loop can be controlled to start ti operate. In this way, the circulating fan can be protected and the service life of the circulating fans can be improved because the circulating fans start to operate after the bearing grease of the circulating fans is heated to the target temperature when it is radiated by electric heating.

In some embodiments, after the main power loop starts to operate, the controller can still monitor the detected temperature collected by the temperature sensor in real time, so as to determine an operating state of the electric control box. The controller can determine a temperature interval where the detected temperature is disposed. In response to the detected temperature is disposed in a first temperature interval, the heating component is controlled to be in an on state; in response to the detected temperature is disposed in a second temperature interval, the state of the heating component is controlled to be unchanged; and in response to the detected temperature is disposed in a third temperature range, the heating component is controlled to be in an off state.

Among them, the first temperature interval is an interval less than a first temperature threshold, the second temperature interval is an interval greater than or equal to the first temperature threshold and less than a second temperature threshold, the third temperature interval is an interval greater than or equal to the second temperature threshold, where the first temperature interval is less than the second temperature threshold.

Illustratively, after the main power loop is started to operate, the detected temperature T of the temperature sensor can be continuously determined. When the detected temperature T is between [a,b], the state of the heating component remains unchanged and keeps off or on; when the cavity temperature T is greater than b, the heating component keeps off and the main power loop keeps operating; when the cavity temperature T is less than a, the heating component keeps on and the main power loop keeps operating.

It should be noted that the circulating fans provided by the embodiments of the present application can not only form a thermal cycle inside the electric control box, but also cool the electric control box when the electric heating component is turned off in response to the temperature of the electric control box is high.

In some embodiments, when the temperature is too high, the controller can firstly acquire an overall power of the electric control box, and then determine an operating wind speed of the circulating fans based on the detected temperature of the temperature sensor and the overall power of the electric control box, so as to determine the circulating fans to dissipate heat from the electric control box.

Illustratively, when the detected temperature T is greater than a preset value c, it can be determined that the temperature of the electric control box is too high and it needs to perform heat dissipation. In response to the overall power s is smaller than the first power threshold S 1, it can be determined that the heat generated by the components in the electric control box is small. At this time, the operating wind speed of the circulating fans is a first target operating wind speed C or stop operating.

Illustratively, when the detected temperature T is greater than the preset value c, and in response to the overall power s is greater than or equal to the first power threshold S 1, it can be determined that the components in the electric control box has generated more heat. At this time, the controller can further determine a heat dissipation condition of the electric control box by acquiring the cavity temperature of the electric control box. In response to the detected temperature T acquired is less than a preset value d, the heat dissipation effect is good, and accordingly, the operating wind speed of the circulating fans can be the second target operating wind speed B.

Illustratively, when the detected temperature T is greater than the preset value c, and in response to the overall power s is greater than or equal to the first power threshold S 1, it can be determined that the heat generated by the components in the electric control box is large. At this time, in response to the detected temperature T acquired is greater than or equal to the preset value d, the heat dissipation effect is poor, and accordingly, the operating wind speed of the circulating fans can be the third target operating wind speed A.

Among them, the third target operating wind speed A is greater than the second target operating wind speed A, and the second target operating wind speed A is greater than the third target operating wind speed C.

In the heat dissipation method for the electric control box provided by the embodiments of the present application, firstly, a detected temperature of a temperature sensor in the electric control box is acquired; subsequently, a heating component in the electric control box is subsequently controlled to heat the electric control box according to the detected temperature; finally, circulating fans in the electric control box are sequentially driven to conduct internal circulation heating for the electric control box according to a heating time of the heating component. In the heat dissipation control method for the electric control box disclosed by the present application, the heating component is controlled to heat the electric control box according to the detected temperature, and the circulating fans are controlled to conduct internal circulation heating, thereby reducing the probability that the components inside the electric control box are damaged due to over-high temperature in an accessory area of the heating component.

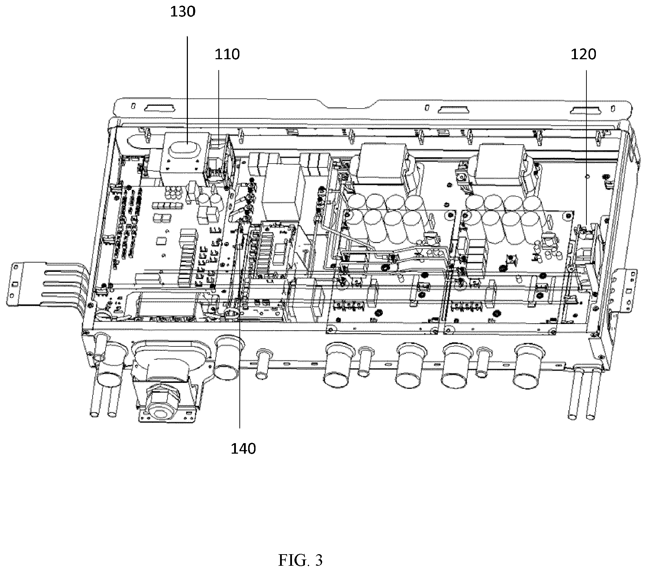

FIG. 3 is a schematic diagram of an electric control box provided by an embodiment of the present application. As shown in FIG. 3, the electric control box adopts a sealed design, and a first circulating fan 110 and a second circulating fan 120 are provided inside the electric control box to conduct circulation heating inside the electric control box. In some embodiments, a third circulating fan, a fourth circulating fan, etc. can be added inside the electric control box to form air circulation.

With continued reference to FIG. 3, a PTC thermistor 130 is provided inside the electric control box as a heating component for heating the electric control box. The PTC thermistor 130 may be installed at an air inlet of the first circulating fan 110, so that the first circulating fan 110 can circulate the heat generated by the PTC thermistor 130 in time. A temperature sensor 140 can also be provided inside the electric control box, and the temperature sensor 140 can be provided anywhere in the electric control box except a position near the PTC thermistor 130, so as to detect the cavity temperature of the electric control box.

It should be understood that the circulating fans provided by the present application can not only form air circulation inside the electric control box, so as to heat the electric control box, but also realize circulating heat dissipation when the temperature of the electric control box is too high.

It should be understood that the electric control box provided by the present application has a closed structure, and its interior adopts a micro-channel refrigeration mode, and the air inside the electric control box is circularly dissipated by a heat dissipation fan, which is not affected by the external ambient temperature and air quality, and the electric control schemes in different regions can be consistent.

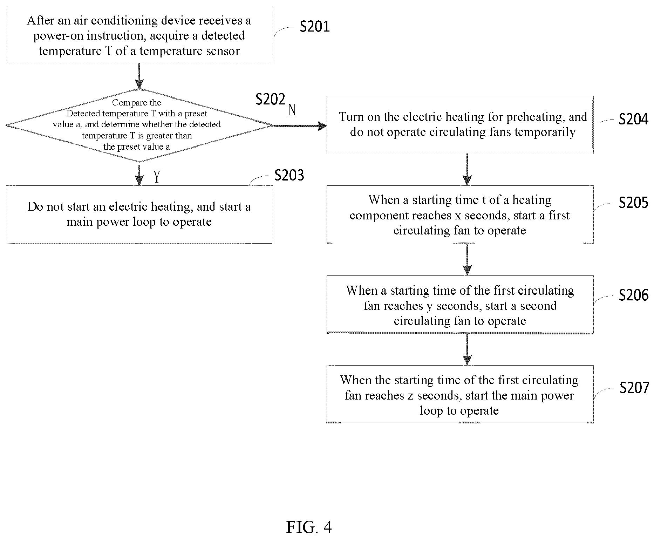

Based on the structure of the electric control box shown in FIG. 3, the corresponding heating control method for the electric control box is provided below. FIG. 4 is a schematic flowchart of another heating control method for an electric control box provided by an embodiment of the present application. As shown in FIG. 4, the heating control method for the electric control box includes the following steps.

S201: after an air conditioning device receives a power-on instruction, acquire a detected temperature T of a temperature sensor.

S202: compare the detected temperature T with a preset value a, and determine whether the detected temperature T is greater than the preset value a.

If yes, step S203 is executed; if no, step S204 is executed.

S203, do not start an electric heating, and start a main power loop to operate.

S204, turn on the electric heating for preheating, and do not operate circulating fans temporarily.

S205: when a starting time t of a heating component reaches x seconds, start a first circulating fan to operate.

It should be understood that when the starting time t reaches x seconds, when the starting time T reaches x seconds, a bearing grease of the first circulating fan is electrically heated to a target temperature by thermal radiation, and then the first circulating fan can be started to operate.

S206: when a starting time of the first circulating fan reaches y seconds, start a second circulating fan to operate.

It should be understood that when the starting time of the first circulating fan reaches y seconds, the first circulating fan can transfer the heat of electric heating to the second circulating fan, so that a bearing grease of the second circulating fan is heated to the target temperature, and the second circulating fan can be started to operate at this time.

S207: when the starting time of the first circulating fan reaches z seconds, start the main power loop to operate.

It should be understood that when the starting time of the first circulating fan reaches z seconds, the heat of electric heating is uniformly transferred to the electric control box by the two circulating fans, and the electric control box finishes heating at this time, so that the main power loop can be operated normally.

In some embodiments, the operating time of the main power loop can also be determined according to an operating time of the last circulating fan (which is the second circulating fan in this embodiment).

It should be noted that the preset values a, x, y and z involved in the embodiments of the present application can be specifically set according to the actual situation, which is not limited in the embodiments of the present application.

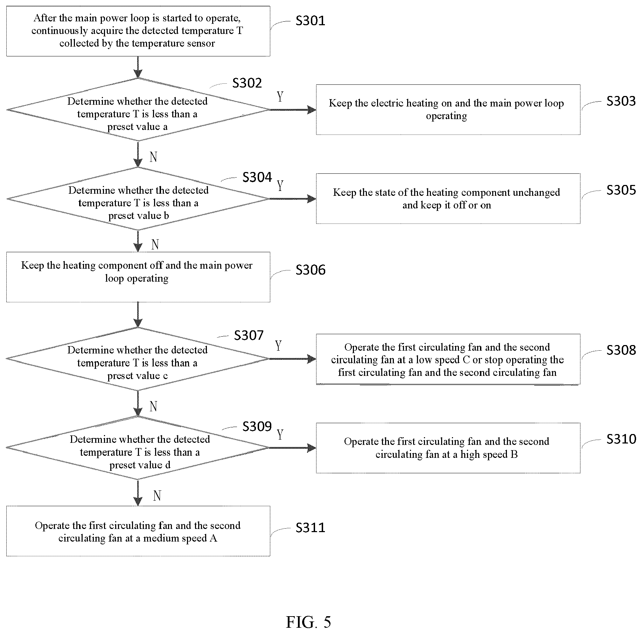

On the basis of the heating control method for the electric control box provided in the above embodiment, the operation control of the main power loop after the electric control box is heated by the heating component will be described below. FIG. 5 is a schematic flowchart of yet another heating control method for an electric control box provided by an embodiment of the present application. As shown in FIG. 5, the heating control method for the electric control box includes the following steps.

S301: after the main power loop is started to operate, continuously acquire the detected temperature T collected by the temperature sensor.

S302: determine whether the detected temperature T is less than a preset value a.

If yes, step S303 is executed; if no, step S304 is executed.

S303: keep the electric heating on and the main power loop operating.

S304: determine whether the detected temperature T is less than a preset value b.

If yes, step S305 is executed; if no, step S306 is executed.

S305: keep the state of the heating component unchanged and keep it off or on.

S306: keep the heating component off and the main power loop operating.

S307: determine whether the detected temperature T is less than a preset value c.

If yes, step S308 is executed; if no, step S309 is executed.

S308: operate the first circulating fan and the second circulating fan at a low speed C or stop operating the first circulating fan and the second circulating fan.

S309: determine whether the detected temperature T is less than a preset value d.

If so, step S310 is executed, and if not, step S311 is executed.

S310: operate the first circulating fan and the second circulating fan at a high speed B.

S311: operate the first circulating fan and the second circulating fan at a medium speed A.

In the embodiment of the present application, a closed electric control box is adopted, and circulating fans are used inside for heat circulation and heat dissipation. A heating component is added at an air inlet of the circulating fans, and the heat of the heating component is transferred through the components inside the electric control box by the circulating fans. In this way, not only can it not be affected by an external air duct, but also the closed electric control box can isolate the heat conduction of the external low-temperature air to a certain extent. Among them, the heating component can be a PTC thermistor. When the fans stop operating and electric heating is dry-fired, due to the characteristics of the PTC thermistor, the resistance of the PTC thermistor increases, the power decreases, and a surface temperature reaches a certain value, but this maximum temperature will not damage the components around the PTC thermistor, thus playing a certain protective role. Moreover, due to the internal circulation of air in the electric control box, it can keep warm to a certain extent, thus making the power of the PTC smaller.

Therefore, the heating control method for the electric control box provided by the embodiment of the present application can prolong the service life of the circulating fan and components in the electric control box to a certain extent, and the main power loop device does not need to be specially treated at low temperature, so that it is universal.

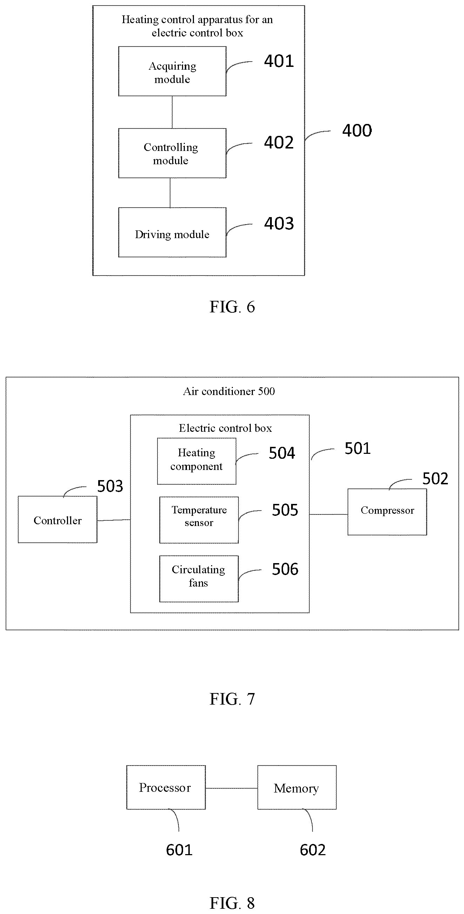

FIG. 6 is a schematic diagram of a heating control apparatus for an electric control box provided by an embodiment of the present application. The heating control apparatus for the electric control box can be realized by software, hardware or a combination of the two, such as the controller in the above embodiments, to execute the heating control method for the electric control box in the above embodiments. As shown in FIG. 6, the heating control apparatus 400 for the electric control box includes an acquiring module 401, a controlling module 402 and a driving module 403.

The acquiring module 401 is configured to acquire a detected temperature of a temperature sensor in the electric control box.

The controlling module 402 is configured to control a heating component in the electric control box to heat the electric control box according to the detected temperature.

The driving module 403 is configured to sequentially drive circulating fans in the electric control box to conduct internal circulation heating of the electric control box according to a heating time of the heating component.

Optionally, the circulating fans include a first circulating fan and a second circulating fan, where the first circulating fan is configured to blow the air in the electric control box to a first direction of the first circulating fan, and the second circulating fan is configured to blow the air in the electric control box to a second direction of the second circulating fan, the first circulating fan is adjacent to the heating component, the second circulating fan is disposed in the first direction of the first circulating fan, and the first circulating fan is disposed in the second direction of the second circulating fan.

Optionally, the driving module 403 is specifically configured to drive the first circulating fan to operate in response to the heating time of the heating component exceeds a first time threshold.

Optionally, the driving module 403 is specifically configured to drive the second circulating fan to operate in response to an operating time of the first circulating fan exceeds a second time threshold.

Optionally, the controlling module 402 is further configured to start a main power loop in the electric control box in response to the operating time of the first circulating fan exceeds a third time threshold.

Optionally, the controlling module 402 is specifically configured to determine whether the detected temperature of the temperature sensor is less than a first temperature threshold; and control the heating component in the electric control box to heat the electric control box in accordance with a determination that the detected temperature of the temperature sensor is less than a first temperature threshold.

Optionally, the controlling module 402 is further configured to start a main power loop in the electric control box in accordance with a determination that the detected temperature of the temperature sensor is greater than or equal to a first temperature threshold.

Optionally, the controlling module 402 is further configured to control a working state of the heating component according to a temperature interval where the detected temperature is disposed.

Optionally, the controlling module 402 is specifically configured to, in response to the detected temperature is disposed in a first temperature interval, control the heating component to be in an on state; in response to the detected temperature is disposed in a second temperature interval, control the state of the heating component to be unchanged; and in response to the detected temperature is disposed in a third temperature interval, control the heating component to be in an off state.

Optionally, the first temperature interval is an interval less than a first temperature threshold, the second temperature interval is an interval greater than or equal to the first temperature threshold and less than a second temperature threshold, the third temperature interval is an interval greater than or equal to the second temperature threshold, where the first temperature interval is less than the second temperature threshold.

It should be noted that the heating control apparatus for the electric control box provided by the embodiment shown in FIG. 6 can be used to implement the method in any of the above embodiments. The specific implementation method and technical effect are similar, so details will not be described here again.

FIG. 7 is a schematic diagram of an air conditioner provided by an embodiment of the present application. As shown in FIG. 7, the air conditioner 500 includes an electric control box 501, a compressor 502 and a controller 503. The electric control box is configured to control refrigeration of the compressor. The electric control box is provided with a heating component 504, a temperature sensor 505 and circulating fans 506. The controller 503 is configured to perform the heating control method for the electric control box which is described above.

FIG. 8 is a schematic diagram of an electronic device provided by an embodiment of the present application. As shown in FIG. 8, the electronic device may include at least one processor 601 and a memory 602. FIG. 8 shows an electronic device with a processor as an example.

The memory 602 is configured to store programs. Specifically, the programs may include program codes, which include computer-executable instructions.

The memory 602 may include a high-speed RAM memory, and may also include a non-volatile memory (non-volatile memory), such as at least one disk memory.

The processor 601 is configured to execute computer-executed instructions stored in the memory 602 to realize the above heating control method for the electric control box;

The processor 601 may be a central processing unit (Central Processing Unit, CPU for short), or an application specific integrated circuit (Application Specific Integrated Circuit, ASIC for short), or one or more integrated circuits configured to implement the embodiments of the present application.

Alternatively, in specific implementation, in response to the communication interface, the memory 602 and the processor 601 are realized independently, the communication interface, the memory 602 and the processor 601 can be connected with each other and complete communication with each other through a bus. The bus can be an Industry Standard Architecture (Industry Standard Architecture, ISA) bus, a Peripheral Component (Peripheral Component, PCI) bus or an Extended Industry Standard Architecture (Extended Industry Standard Architecture, EISA) bus. The bus can be address bus, data bus, control bus, etc., but it does not mean that there is only one bus or one type of bus.

Optionally, in specific implementation, in response to the communication interface, the memory 602 and the processor 601 are integrated on one chip, the communication interface, the memory 602 and the processor 601 can complete communication through an internal interface.

The embodiments of the present application also provide a chip that includes a processor and an interface. The interface is configured to input and output data or instructions processed by the processor. The processor is configured to execute the method provided in the method embodiments above. The chip can be applied to the heating control apparatus for the electric control box.

the present application also provides a computer-readable storage medium, which may include various medium that can store program codes, such as a U disk, a mobile hard disk, a Read-Only Memory (ROM, Read-Only Memory), a Random Access Memory (RAM, Random Access Memory), a magnetic disk or an optical disk, etc. Specifically, the computer-readable storage medium stores program information which is used for the above heating control method for the electric control box.

The embodiments of the present application also provide a program, which is configured to execute the heating control method for the electric control box provided by the above method embodiments when executed by a processor.

The embodiments of the present application also provide a program product, such as a computer-readable storage medium, the program product stores instructions and causes the computer to execute the heating control method for the electric control box provided by the above method embodiments when operated on a computer.

In the above embodiments, it can be achieved in whole or in part by software, hardware, firmware, or any combination thereof. When using software, it can be implemented in whole or in part in the form of a computer program product. A computer program product consists of one or more computer instructions. When computer-executable instructions are loaded and executed on a computer, the process or function in accordance with the present application embodiments is generated in whole or in part. A computer may be a general purpose computer, a special purpose computer, a computer network or other programmable device. Computer instructions may be stored in computer readable storage medium, or transferred from one computer readable storage medium to another computer readable storage medium, for example, computer instructions may be transmitted from one site, computer, server or data center via wire (e.g., coaxial cable, fiber optic, digital subscriber line (DSL)) or wireless (e.g., infrared, wireless, microwave, etc.) to another site, computer, server or data center. A computer readable storage medium can be any available medium that a computer can access or a data storage device that contains one or more available medium integrated, such as a server or data center. The available medium can be magnetic medium (e.g., floppy disk, hard disk, magnetic tape), optical medium (e.g., DVD), or semiconductor medium (e.g., Solid State Disk (SSD)), etc.

In the description of the present application, it needs to be understood that the locations or position relationships instructed by the term "center", "vertical", "horizontal", "length", "width", "thickness", "up", "down", "before", "after", "left", "right", "vertical", "horizontal", "top", "bottom", "in", "out", "clockwise", "anticlockwise", "axial", "radial", "circumferential", etc are locations or position relationships based on the attached drawings and only intended to facilitate and simplify the description of the present application, which are not intended to indicate or imply that the device or element referred to must have a particular orientation, construction or operation in a particular orientation, and therefore shall not be understood as a limitation of the present application.

In the description of this specification, the description of the reference terms "an embodiment", "some embodiments", "examples", "specific examples" or "some examples" means that specific features, structures, materials or characteristics described in connection with this embodiment or example are included in at least one embodiment or example of the present application. In this specification, the schematic expressions of the above terms are not necessarily aimed at the same embodiment or example. Moreover, the specific features, structures, materials or characteristics described may be combined in any one or more embodiments or examples in a suitable manner. In addition, a person skilled in the art can combine different embodiments or examples and the features of different embodiments or examples described in this specification without contradicting each other.

Although the embodiments of the present application have been shown and described above, it can be understood that the above embodiments are exemplary and cannot be understood as limitations of the present application, and a person skilled in the art can make changes, modifications, substitutions and variations to the above embodiments within the scope of the present application.

## Claims

1. A heating control method for an electric control box, comprising:
acquiring a detected temperature of a temperature sensor in the electric control box;
controlling a heating component in the electric control box to heat the electric control box according to the detected temperature; and
sequentially driving circulating fans in the electric control box to conduct internal circulation heating of the electric control box according to a heating time of the heating component.

2. The method according to claim 1, wherein the circulating fans comprise a first circulating fan and a second circulating fan, the first circulating fan is configured to blow air in the electric control box in a first direction of the first circulating fan, and the second circulating fan is configured to blow the air in the electric control box in a second direction of the second circulating fan, the first circulating fan is adjacent to the heating component, the second circulating fan is disposed in the first direction of the first circulating fan, and the first circulating fan is disposed in the second direction of the second circulating fan.

3. The method according to claim 2, wherein the sequentially driving the circulating fans in the electric control box to conduct the internal circulation heating of the electric control box according to the heating time of the heating component comprises:
driving the first circulating fan to operate in response to the heating time of the heating component exceeds a first time threshold.

4. The method according to claim 3, wherein the sequentially driving the circulating fans in the electric control box to conduct the internal circulation heating of the electric control box according to the heating time of the heating component further comprises:
driving the second circulating fan to operate in response to an operating time of the first circulating fan exceeds a second time threshold.

5. The method according to claim 4, wherein after the sequentially driving the circulating fans in the electric control box to conduct the internal circulation heating of the electric control box according to the heating time of the heating component, the method further comprises:
starting a main power loop in the electric control box in response to the operating time of the first circulating fan exceeds a third time threshold.

6. The method according to claim 1, wherein the controlling the heating component in the electric control box to heat the electric control box according to the detected temperature comprises:
in accordance with a determination that the detected temperature of the temperature sensor is less than a first temperature threshold, controlling the heating component in the electric control box to heat the electric control box.

7. The method according to claim 6, wherein the method further comprises:
in accordance with a determination that the detected temperature of the temperature sensor is greater than or equal to a first temperature threshold, starting a main power loop in the electric control box.

8. The method according to claim 5 or 7, wherein after the starting the main power loop in the electric control box, the method further comprises:
controlling a working state of the heating component according to a temperature interval where the detected temperature is disposed.

9. The method according to claim 8, wherein the controlling the working state of the heating component according to the temperature interval where the detected temperature is disposed comprises:
in response to the detected temperature is disposed in a first temperature interval, controlling the heating component to be in an on state;
in response to the detected temperature is disposed in a second temperature interval, controlling the state of the heating component to be unchanged; and
in response to the detected temperature is disposed in a third temperature interval, controlling the heating component to be in an off state;
wherein the first temperature interval is an interval less than a first temperature threshold, the second temperature interval is an interval greater than or equal to the first temperature threshold and less than a second temperature threshold, the third temperature interval is an interval greater than or equal to the second temperature threshold, wherein the first temperature interval is less than the second temperature threshold.

10. The method according to claim 1, wherein the temperature sensor is configured to detect a cavity temperature of the electric control box.

11. The method according to claim 1, wherein the heating component comprises a positive temperature coefficient thermistor.

12. A heating control apparatus for an electric control box, comprising:
an acquiring module, configured to acquire a detected temperature of a temperature sensor in the electric control box;
a controlling module, configured to control a heating component in the electric control box to heat the electric control box according to the detected temperature; and
a driving module, configured to sequentially drive circulating fans in the electric control box to conduct internal circulation heating of the electric control box according to a heating time of the heating component.

13. An air conditioner, comprising an electric control box, a compressor and a controller, wherein:
the electric control box is configured to control refrigeration of the compressor, and the electric control box is provided with a heating component, a temperature sensor and circulating fans; the controller is configured to:
acquire a detected temperature of the temperature sensor in the electric control box;
control the heating component in the electric control box to heat the electric control box according to the detected temperature; and
sequentially drive the circulating fans in the electric control box to conduct internal circulation heating of the electric control box according to a heating time of the heating component.

14. A computer program product, comprising a computer program, wherein when the computer program is executed by a processor, the method according to any one of claims 1 to 11 is realized.

15. A computer storage medium, wherein the computer storage medium stores a plurality of instructions, and the instructions are suitable for being loaded by a processor and executing the steps of the method according to any one of claims 1 to 11.
